# Europäisches Patentamt

(19) **European Patent Office**

**Office européen des brevets**

(11) Publication number: **0 032 401**
**B1**

(12) **EUROPEAN PATENT SPECIFICATION**

(45) Date of publication of patent specification: **14.08.85**

(51) Int. Cl.⁴: **H 01 S 3/19**

(21) Application number: **81100192.4**

(22) Date of filing: **13.01.81**

(54) Semiconductor laser.

(30) Priority: **14.01.80 JP 2777/80**
**05.02.80 JP 13159/80**
**19.02.80 JP 20256/80**
**14.03.80 JP 32981/80**
**19.03.80 JP 35292/80**
**19.03.80 JP 35293/80**
**19.03.80 JP 35296/80**
**16.05.80 JP 65555/80**

(43) Date of publication of application:
**22.07.81 Bulletin 81/29**

(45) Publication of the grant of the patent:
**14.08.85 Bulletin 85/33**

(84) Designated Contracting States:
**DE FR GB**

(56) References cited:
**FR-A-2 426 992**
**US-A-3 780 358**
**APPLIED PHYSICS LETTERS, vol. 34, no. 4,
February 1979, New York, US T. SUGINO et al.
"Terraced-substrate GaAs-(GaAl) As injection
lasers", pages 270-272**

(73) Proprietor: **Matsushita Electric Industrial Co.,
Ltd.**
**1006, Oaza Kadoma
Kadoma-shi Osaka-fu, 571 (JP)**

(72) Inventor: **Itoh, Kunio
78-1, Kohata-Minamiyama
Uji City, 611 (JP)**
Inventor: **Sugino Takashi
12-8, Hyuga-cho
Takatsuki City, 569 (JP)**
Inventor: **Wada, Masaru
425, Sharuman Kohpo 21-1, Ohata-cho
Takatsuki City, 569 (JP)**
Inventor: **Shimizu, Hirokazu
2-5, Honmachi 6-chome
Toyonaka City, 560 (JP)**

(74) Representative: **Dr. Elisabeth Jung Dr. Jürgen
Schirdewahn Dipl.-Ing. Claus Gernhardt
P.O. Box 40 14 68 Clemensstrasse 30
D-8000 München 40 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to an improvement in a semiconductor laser of terraced substrate type.

Semiconductor lasers have the advantages of small bulk, high efficiency and direct modulation by means of its current and therefore in the future will be used as light sources e.g. for optical communication, optical data processing. For such applications semiconductor lasers have to possess the characteristics of stable fundamental transverse mode lasing, low threshold current, high output of light and high reliability.

With a conventional laser which has a structure of simple gain guiding there is the difficulty in maintaining a transverse mode for a wide range of current, and therefore an undesirable mode conversion or a generation of higher modes are liable to occur. As a result the light-current characteristic curve is likely to have a kink or the laser device is likely to have a multiple lengthwise mode oscillation.

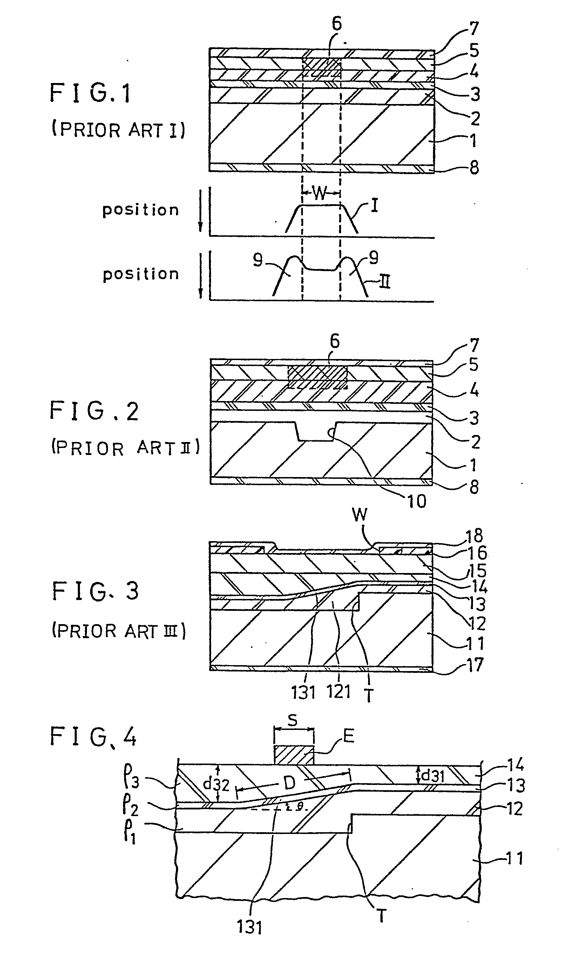

Fig. 1, Fig. 2 and Fig. 3 show various types of conventional semiconductor stripe lasers. The laser shown in Fig. 1 is a planar stripe laser and has a double hetero structure. It comprises on a substrate 1 of ... n-GaAs

a first clad layer 2 of ... n-GaAlAs,

an active layer 3 of ... non-doped GaAs,

a second clad layer 4 of ... p-GaAlAs and

an isolation layer 5 of ... n-GaAlAs, which forms a p-n isolation junction between itself and the underlying p-type second clad layer 4 and has a

strip shaped current injection region 6 in form of a ... p-type diffused region formed by diffusing an acceptor such as Zn, in a manner to penetrate it and diffuse into the midway of the second clad layer.

Numerals 7 and 8 designate the p-side and n-side electrodes ohmicly contacting the current injection region 6 and the substrate 1, respectively.

In such a planar stripe laser, the active layer has a flat structure and has a uniform refractive index on all parts thereof. Therefore, the light confinement in the stripe shaped region is not sufficient. Besides, current injected from the current injection region 6 is likely to spread as shown by the curve I of Fig. 1 and spread parts around both sides of the curve do not contribute to the oscillation. As the width W becomes narrower until it becomes 7 µm, the threshold current gradually decreases. However, it is found that when the width becomes smaller than 7 µm, the threshold current of the laser increases. It is supposed that when the width W is smaller than 7 µm. the spreading current flowing at both side parts of the curve I increases in relation to the effectual current flowing at the center of the curve I. Furthermore, when the injected current is increased, the light distribution assumes a characteristic as shown by curve II of Fig. 1, that is on both side parts the light intensity is high which results in oscillations on these side parts and thereby the uniformity of oscillation gets lost.

Fig. 2 shows the structure of another conventional laser, wherein the substrate 1 has a groove 10 with a strip shaped pattern. On the substrate 1 a first clad layer 2 and an active layer 3 and known subsequent layers 4 and 5 are formed. In this laser, the stability of single mode oscillations is improved in comparison with the laser shown in Fig. 1. However the structure of the active layer per se is still flat similar to the structure of Fig. 1. Therefore there is no means to limit spreading of the injected current. Accordingly, the threshold current is not sufficiently reduced.

Fig. 3 shows still another example of the conventional lasers, which was proposed by a few of the inventors of the present invention. This laser has

a terrace shaped substrate of ... n-GaAs, and thereon epitaxial layers of

a first clad layer 12 of ... n-Ga$_{1-x}$Al$_x$As,

an active layer 13 having an oblique lasing region 131 of ... (non-doped) Ga$_{1-y}$Al$_y$As,

a second clad layer 14 of ... p-Ga$_{1-x}$Al$_x$As and

a cap layer 15 of ... p-GaAs.

Thereon insulation layers 16 and 16 of, for example, SiO$_2$ are formed which have a stripe shaped opening at the position above the oblique region 131. Electrodes 18 and 17 are formed on the p-side and n-side of the substrate. In this laser the active layer comprises a lasing oblique region 131 which is defined by an upper bending part and a lower bending part confining light emission therebetween. The first clad layer 12 has a triangular thick part 121 below the oblique region 131 and an upper thinner part and a lower thinner part below an upper horizontal part and a lower horizontal part of the active layer 13, respectively. Therefore the thick part 121 of the first clad layer 12 serves to prevent transmission of light into the substrate 11, while the thinner parts of the first clad layer 12 serve to allow transmission of light therethrough into the substrate 11. Because of the different transmittance of light of the active layer 13 to the substrate 11, the light is effectively confined in the oblique region 131 which is lying on the thick part 121 and between the two bending parts. As a result a single transverse mode oscillation is easily obtainable. The laser can be manufactured easily and has a long lifetime because of its reasonable crystal structure. However, there is the disadvantage that a part of the injected current still flows into the upper and lower horizontal parts of the active layer 13 which results in ineffective currents there so that confinement of the injected current in the oblique region is difficult. Thus the external differential quantum efficiency is not sufficiently high. Besides, in order to prevent undesirable parasitic oscillations in the active layer 13 at parts other than the oblique region 131, the first clad layer 12 should extremely thin at the parts not below the oblique region 131. However, it is not easy to form the clad layer extremely thin.

The present invention purposes to provide an improved laser capable of stable fundamental mode lasing at a low threshold current.

A semiconductor laser according to the invention comprises

a terraced-shaped semiconductor substrate having a thinner part and a thicker part with a step inbetween,

a first semiconductor clad layer formed on said substrate and having a lower part formed on said thinner part, an upper part formed on said thicker part and a central part formed to connect said lower part and said upper part and having an oblique upper face with respect to the principal face of said substrate and having a larger thickness than those of the lower part and the upper part,

an active semiconductor layer formed on said first clad layer and having a horizontal lower part formed on said lower part of the first clad layer, a horizontal upper part formed on said upper part of the first clad layer and an oblique central region as a lasing region formed on said central part of said first clad layer and connecting said horizontal lower part and said horizontal upper part therewith with a lower bending and an upper bending inbetween, and

a second semiconductor clad layer formed on said active layer, the improvement being that

a current injection region of a stripe-shaped pattern is formed penetrating said second clad layer to contact the latter at a part above said oblique central region of the active layer forming an ohmic junction with the second clad layer, the junction having a width which is equal to or smaller than a width of said oblique central region.

The present invention provides a laser wherein the threshold current monotonously decreases as the width of the current injection region is decreased. Furthermore, the present invention allows to limit the effective width of the current injection region and to retain single mode lasing for a wide range of currents.

In the following preferred examples showing the advantages of the invention will be described referring to the drawing in which

Fig. 1 is a sectional elevation view of an example of a conventional planar type semiconductor laser,

Fig. 2 is a sectional elevation view of an example of another type of a conventional semiconductor laser,

Fig. 3 is a sectional elevation view of an example of a conventional terraced substrate type laser,

Fig. 4 is a sectional elevation view of a semiconductor laser embodying the present invention,

Fig. 5 and Fig. 6 are graphs which show the relation between the current confinement rate and the specific resistance of the active layer and the curves of which have been calculated,

Fig. 7(A), Fig. 7(B) and Fig. 7(C) are sectional elevation views showing examples embodying the present invention,

Fig. 8 and Fig. 9 are graphs showing empirical characteristics of the laser of Fig. 7(C),

Fig. 10(a), Fig. 10(b), Fig. 10(c) and Fig. 10(d) are sectional elevation views showing manufacturing steps of the laser of Fig. 7(C),

Fig. 11(a), Fig. 11(b) and Fig. 11(c) are sectional elevation views showing manufacturing steps of another example of a laser according to the invention,

Fig. 11(d), Fig. 11(e), Fig. 11(f), Fig. 11(g) and Fig. 11(h) are graphs showing characteristics of the laser of Fig. 11(c),

Fig. 12(a), Fig. 12(b), Fig. 12(c) and Fig. 12(d) are sectional elevation views showing manufacturing steps of a further example of the invention,

Fig. 13(a), Fig. 13(b), Fig. 13(c) and Fig. 13(d) are sectional elevation views showing manufacturing steps of a further example of the invention,

Fig. 14 is a sectional elevation view of a further example of the invention,

Fig. 15 is a sectional elevation view of a further example of the invention,

Fig. 16(a), Fig. 16(b), Fig. 16(c), Fig. 16(d) and Fig. 16(e) are sectional elevation views showing manufacturing steps of a further example of the invention,

Fig. 17(a) and Fig. 17(b) are sectional elevation views showing manufacturing steps of a further example of the invention, and

Fig. 18(a) and Fig. 18(b) are sectional elevation views showing manufacturing steps of a further example of the invention.

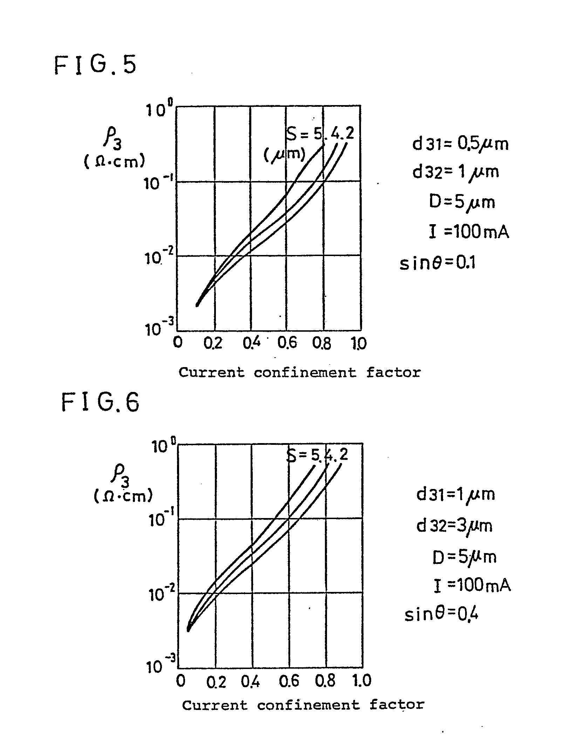

Fig. 4 elucidates the principle of the present invention by a sectional view of a terraced-substrate type semiconductor laser. As can be seen the width S of the contacting region E of the current injection region is smaller than the width D of the oblique central region 131 of the active semiconductor layer 13. $\rho_1$, $\rho_2$, and $\rho_3$ are the specific resistivities of the first semiconductor clad layer 12, the active layer 13 and the second semiconductor clad layer 14. $d_{31}$ and $d_{32}$ are thickness of the second clad layer 14 at its thicker part which is above the horizontal lower part of the active layer 13 and at its thinner part which is above the horizontal upper part of the active layer 13, respectively. $\theta$ is the angle of the oblique central region 131 with the horizontal plane of the horizontal lower part of the active layer 13. The inventors studied the current confinement factor of the lasing region, i.e. of the oblique central region of the active layer, and they found that an insufficient exterior differential quantum efficiency and a high threshold current are caused by a low current confinement factor in the oblique central region, which is the lasing region of the active layer. Then, the inventors made many calculations in order to study samples of the laser shown in Fig. 4. The result of the calculations of samples of this laser is shown in Figs. 5 and 6, in which the abscissa values represent current confinement factor, which is a ratio of the current injected into the oblique central region 131 and the total current injected from the contacting region E of the current injection region, and the ordinate values represent the specific resisticity $\rho_3$ of the second clad layer 14. The parameter of the curves are width S (in μm) of the contacting region E. As can be seen from the curves of Figs. 5 and 6, with the specific resistivity $\rho_3$ being $10^{-2}$ Ω·cm or higher, the current confinement factor is much improved, and especially for the $\rho_3$ of $10^{-1}$ Ω·cm, the current confinement factor becomes so high as 50—80%. The upper limit of $\rho_3$ is determined by manufacture, a reasonable upper limit value of $\rho_3$ may be 1 Ω·cm. Summarizing the above, the specific resistivity $\rho_3$ of the second clad layer 14 influences the way of current spreading, that is the current confinement factor can be improved much by controlling the $\rho_3$ value. Also, when the width S is shorter than D·cosθ, the current confinement factor becomes high. That is, by controlling the $\rho_3$ value so that it is higher than $10^{-2}$ Ω·cm or the S value so that it is smaller than D·cosθ, the current confinement factor can be improved, and thus the threshold current can be made small, and the external differential efficiency $\eta_{ext}$ can be improved.

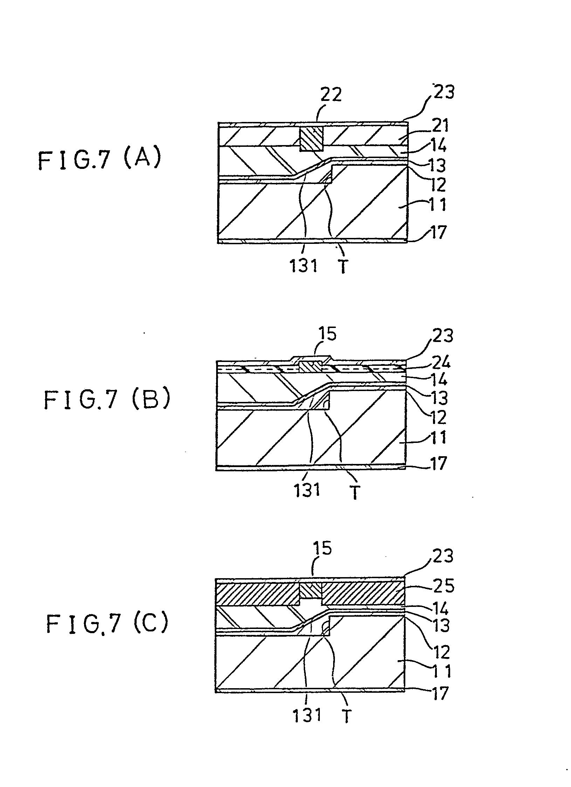

Making use of the above finding the embodiments shown by Fig. 7(A), Fig. 7(B) and Fig. 7(C) were proposed.

The laser of Fig. 7(A) shows a GaAs/GaAlAs laser having, on a p-GaAlAs second clad layer 14, a cap layer 21 of n-GaAs, wherethrough a Zn diffused p-type current region 22 of 3 μm width is formed such that its diffusion front slightly reaches into the underlying second clad layer 14. A p-side electrode 23 is formed on the cap layer 27 forming the ohmic contact to the current injection region 22. The cap layer 21 of n-GaAs and the underlying second clad layer 14 of p-GaAlAs form an isolation junction inbetween except the part of the current injection region 22.

Fig. 7(B) shows another GaAs/GaAlAs laser having, on a p-GaAlAs second clad layer 14 a 3μm width stripe shaped cap layer 15 of p-GaAs, which is formed stripe shape by known selective etching by utilizing, for example, an etchant of $H_2O_2$:$NH_4OH$=20:11, so that only the 3 μm width region of the cap layer 15 is retained on the second clad layer 14. Exposed parts of surface of the second clad layer 14 are then covered by an insulating film 24 of a native oxide film or $SiO_2$ film. Then a p-side electrode 23 is formed to make an ohmic contact with the cap layer 15.

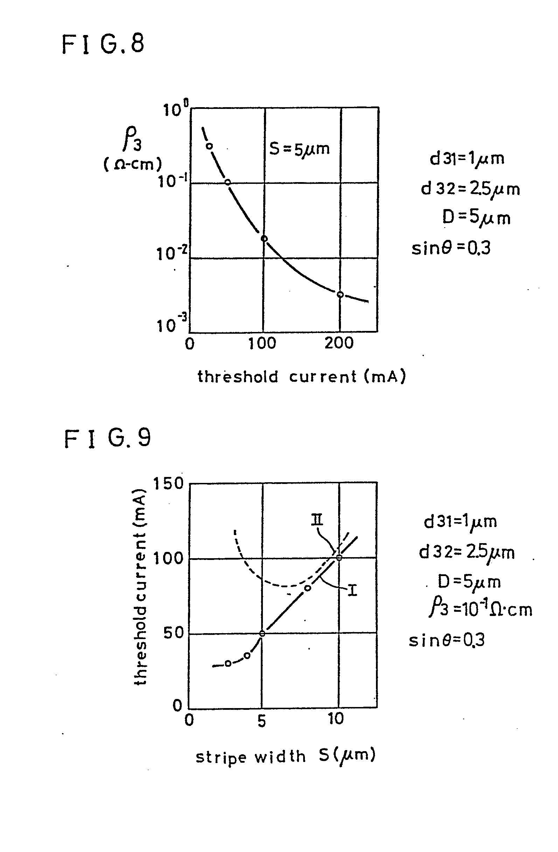

Fig. 7(C) shows still another GaAs/GaAlAs laser having, on a p-GaAlAs second clad layer 14, a 3 μm width stripe shaped cap layer 15 of p-GaAs. The exposed surfaces of the second clad layer 14 are mesa-etched to half of its depth and a high resistivity GaAs layer 25 is formed on the mesa-etched parts by means of known vapor phase epitaxial growth from thermally decomposed gas. Studies have shown that the example of Fig. 7(C) has the smallest threshold value. Figs. 8 and 9 show empirically obtained characteristics of the threshold current with respect to the $\rho_3$ value and the S value of the laser of Fig. 7(C). These graphs shows the coincidence of the characteristics with the calculated curves. When the, $\rho_3$ value the

specific resistivity of the second clad layer 14) is higher than $10^{-2}$ Ω·cm, and the S value (the width of the oblique central part 131 of the effective current injection region) is smaller than D·cosθ (width in plan view of the oblique central region 131 of the active layer 13) they are very effective in reducing the threshold current. As can be seen in Fig. 9, the threshold current becomes smaller as the stripe width S˙becomes narrower, even when the stripe width is smaller than 7 μm as is shown by curve I. This is contrary to the characteristic curve I of the conventional planar stripe lasers as shown in Fig. 1 and Fig. 2 where the threshold current increases as the strip width S becomes smaller than 7 μm.

For the monotonous decrease of the threshold current with the decrease of the effective width of the current injection region even under 7 μm for the case of the terraced substrate type the explanation has been supposed that the bendings on both sides of the oblique central region 131 of the terraced substrate type laser confines light in the oblique central region 131 thereby limiting the lasing region to the oblique central region and hence condensing the light for efficient lasing. As the currents spreading outside of the bendings are substantially ineffective currents, their reduction effectively decreases the redundant ineffective current. In contrast to the abovementioned terraced substrate type laser, the conventional planar stripe laser has no means to confine the light within a region of a certain width, and therefore, the light is not efficiently condensed to an effective density. Accordingly, as the width of the current injection region becomes narrower than 7 μm and hence the current becomes to spread more radially, the density of the light decreases thereby increasing the threshold current.

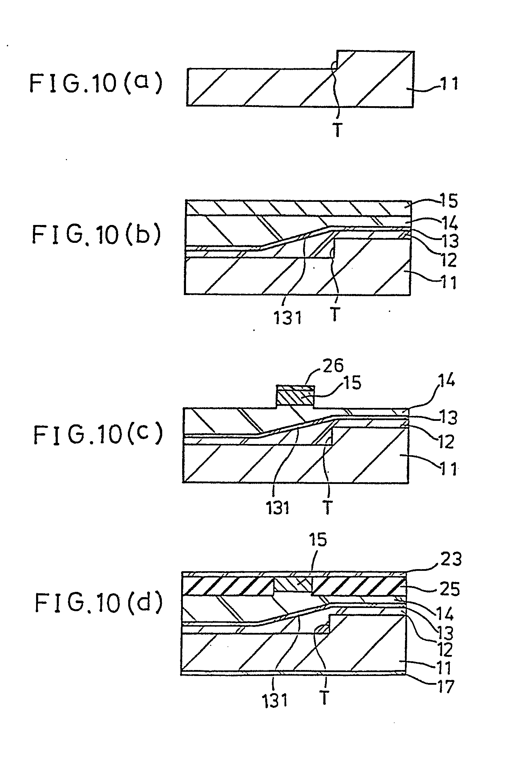

Fig. 10(a), Fig. 10(b), Fig. 10(c) and Fig. 10(d) show steps of manufacturing the laser of Fig. 7(C). On a substrate as shown in Fig. 10(a), i.e, on

a terraced substrate 11 of ... n-GaAs having a terrace step T of height of about 1.5 μm

the following layers are formed by a sequential liquid phase epitaxial growth:

a first clad layer 12 of ... n-$Ga_{0.7}Al_{0.3}$As,

an active layer 13 of ... n-$Ga_{0.95}Al_{0.05}$As,

a second clad layer 14 of ... p-$Ga_{0.7}Al_{0.3}$As, a cap layer 15 of ... p-GaAs,

as shown by Fig. 10(b). The first clad layer 12 has a thickness of 0.3 μm thick at its thinner part and of about 1 μm at its thicker part, so that the light oscillated in the active layer 13 is not absorbed into the substrate 11. The oblique central region, i.e., the lasing region has a width is about 3 μm. The second clad layer 14 has a thickness of about 1 μm thick at its thinner part and of about 2.5 μm thick at its thicker part, so that its upper face becomes flat. The cap layer 15 is about 1.5 μm thick. After the completion of the epitaxial growth an $SiO_2$ film 26 of 5000Å thickness is formed. By means of a known photoetching method, the $SiO_2$ film 26 is etched so that it is retain only at the part of a 3 μm width strip-shaped part above the oblique central region 131. Then by utilizing the 3 μm wide SiO₂ film 26 as an etching mask the cap layer 15 of p-GaAs is etched and further the second clad layer 14 of p-$G_{0.7}Al_{0.3}As$ is also etched to half of its depth as is shown by Fig. 10(c). Thus a current injection region of 3 μm width is provided on the second clad layer 14. Then, by means of a thermal decomposition gas phase growth method, a high resistant GaAs layer 25 is formed to fill the recess spaces etched away on the second clad layer 14, in a manner so that its upper faces have the same level as the top face of the retained stripe shaped p-GaAs cap layer 25. After removing the SiO₂ mask 26 a known p-side electrode 23 is formed on the top face. After etching the bottom face of the substrate 11 in a manner so that the overall thickness of the wafer becomes about 100 μm, a known n-side electrode 17 is formed, and the laser element is completed as shown in Fig. 10(d).

The abovementioned condition that

$$\rho_3 > 10^{-2} \ \Omega\cdot cm$$

is applicable not only to any type of laser which have a substrate with non-flat principal face.

In actual mass production of lasers, it is not very easy to form the current injection region with such a narrow width as 3 μm. Therefore, the belowmentioned example was proposed in order to easily obtain such an effective width of the current injection region as narrow as 2—3 μm.

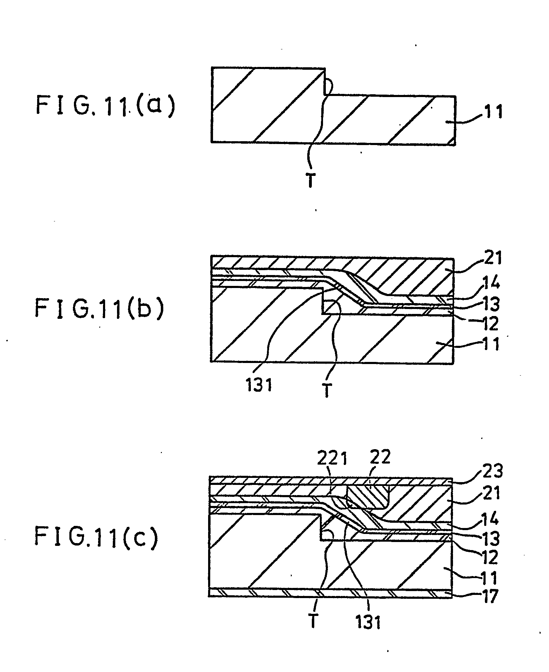

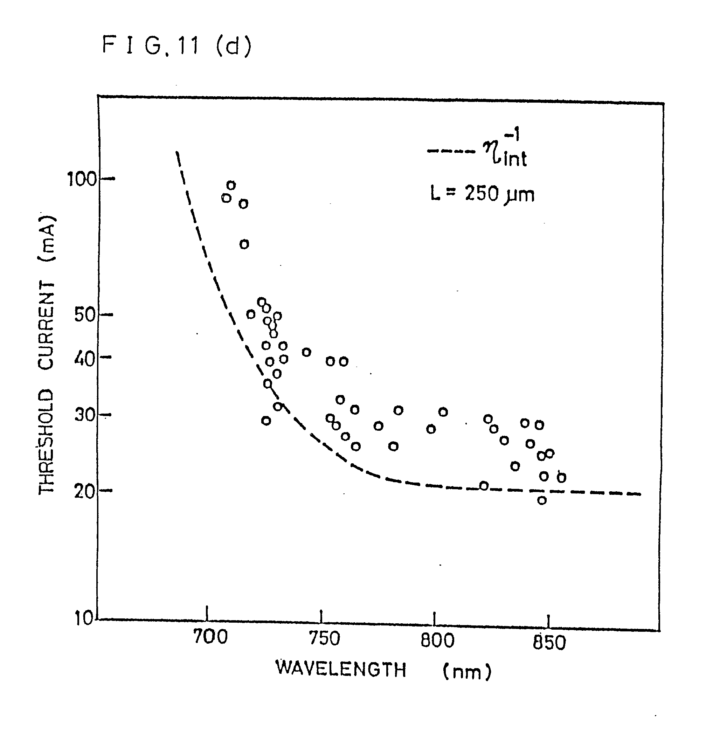

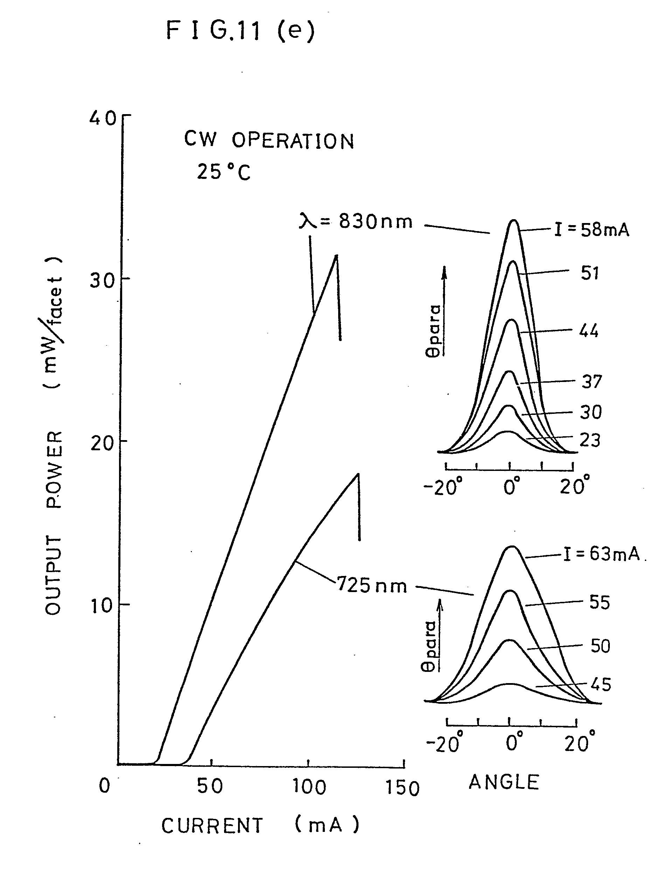

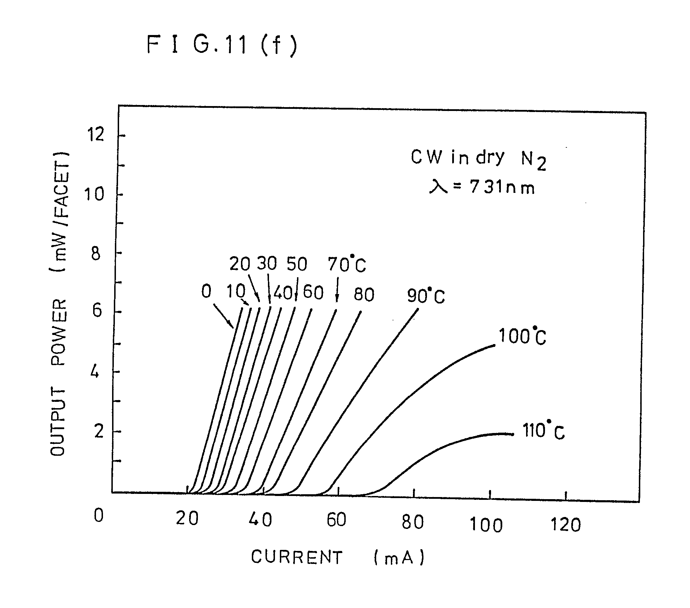

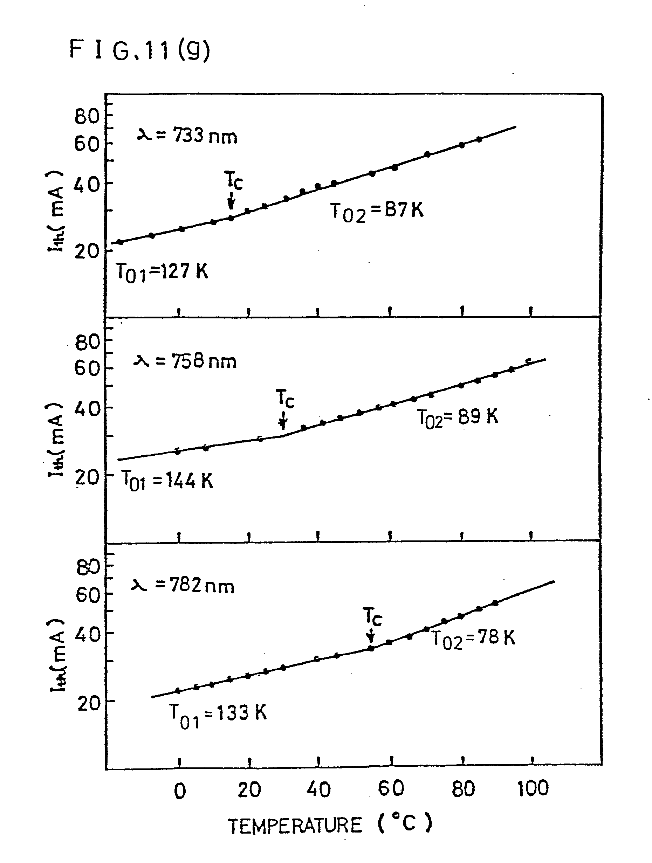

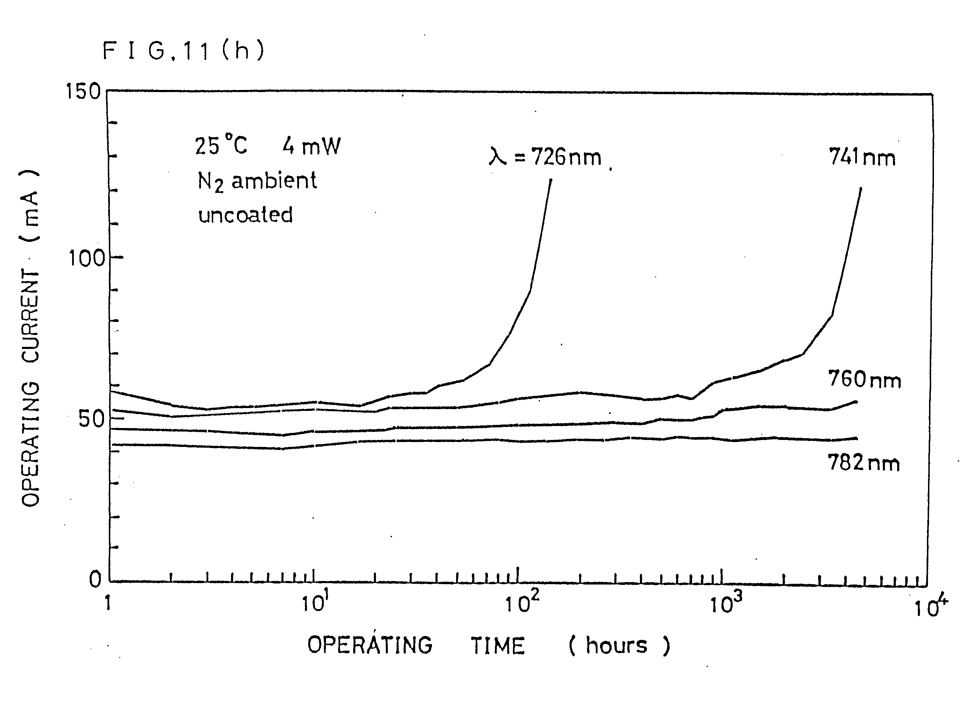

Fig. 11(a) to Fig. 11(c) show manufacturing steps of an example of such a laser. As is shown in Fig. 11(c), a diffused current injection region 22 contacts with the second clad layer 14 of the same conductivity type with its one lower corner, thereby defining an effectively narrow current injection region. Hereinafter the same numerals designate the layers or regions of similar nature.

In the following the manufacture of the laser will be described:

A terrace-shape semiconductor substrate is formed so that it has a step T, and on its surface, a first clad layer 12 of n-GaAlAs is formed by a liquid phase expitaxial growth method, in a manner that at the parts above the thinner and thicker horizontal parts of the substrate 11 the first clad layer 12 is thin enough to allow absorption of evanescent light from the overriding active layer 13 in the substrate 11, and that at the part above the foot of the step part T the first clad layer 12 is such thick as to prevent the transmission of evanescent light from the active layer 13 to the substrate 11 therethrough. Subsequently, the active layer 13 is epitaxially grown on the first clad layer 12, so that the active layer 13 has the oblique central region 131 defined between an upper bending and the lower bending and that the oblique central region 131 is thicker than the horizontal parts of the active layer 13. Subsequently, the second clad layer 14 of p-GaAlAs is expitaxially grown in such a manner that it is thinner at the horizontal parts and thicker at the oblique part which is above the oblique central region 131 in order to prevent thereby transmission of evanescent light from the lasing region 131 of the active layer 13 to the overlying or cap layer 21. The layer 21 of n-GaAs is epitaxially grown in such a manner that it is thicker on the lower horizontal part of the active layer 13 and thinner on the higher horizontal part of the active layer 13, thereby having a p-n isolation junction with two bendings between the active layer 13 and the epitaxial layer 21, as shown in Fig. 11(b). Then, an acceptor such as Zn is selectively diffused in the stripe shaped pattern from the surface of the epitaxial layer 21 to form a current injection region 22 of p-type conductivity. The position and the depth of the diffusion are controlled in such a manner that a corner edge 221 of the current injection region 22 which is near the oblique central region 131 penetrates the epitaxial layer 21 and intrudes into the second clad layer 14 at the part approximately above the center line of the oblique central region 131, thereby forming an ohmic junction of a narrowly controlled width above the center line of the oblique central region 131. The width of the ohmic junction between current injection region 22 and the second clad layer 14 can be easily controlled so that it is smaller than the width of the current injection region 22 by controlling the position and the depth of the current injection region 22. The diffusion of the region 22 should be stopped so as to retain the other corner edge of the current injection region 22 in the epitaxial layer 21. Then, a p-side electrode 23 and an n-side electrode 17 are formed on the upper and the lower face of the wafer as shown in Fig. 11(c).

The manufacture of the GaAs/$Ga_{1-x}Al_xAs$ laser elucidated referring to Fig. 11(a), (b) and (c) will be described more detailedly in the following. A step of 1.5 μm height of <011> direction is formed on the (100) face of an n-GaAs substrate 11 by a known photolithographic technique utilizing an etchant containing sulfuric acid. Then by means of a liquid phase epitaxial growth method, a first clad layer 12 of n-$Ga_{0.7}Al_{0.3}As$ is formed, in such a manner that at the parts above the thinner and the thicker horizontal parts of the substrate 11 the first clad layer 12 is about 0.2 μm thick so as to allow transmission of evanescent light from the overlying active layer 13 to the substrate 11, and that at the part above the foot of the step T the first clad layer 12 is formed about 1 μm thick so as to prevent the transmission of evanescent light from the active layer 13 to the substrate 11 therethrough. Such a thickness can be obtained as the result of the growth rate being higher at the step part. Subsequently, the active layer 13 of non-doped $Ga_{0.95}Al_{0.05}As$ is epitaxially grown on the first clad layer 12, so that the active layer 13 has the oblique central region 131 defined between the upper bending and the lower bending, and that the oblique central region 131 is of about 0.1 μm thick and thus is thicker than the horizontal parts of the active layer 13 which are about 0.08 μm thick. Subsequently, the second clad layer 14 of p-$Ga_{0.65}Al_{0.35}As$ is epitaxially grown, so that it is

about 0.4 µm thick at the horizontal parts and about 1.5 µm thick at the oblique part which is above the oblique central region 131 to prevent thereby transmission of evanescent light from the lasing region 131 of the active layer 13 to the overlying epitaxial layer 21. Subsequently the epitaxial layer 21 of n-GaAs is epitaxially grown in such a manner that it is about 2.5 µm thick on the lower horizontal part of the active layer 13 and about 1 µm thick on the higher horizontal part of the active layer 13, thereby forming a p-n isolation junction with two bendings between the clad layer 14 and the epitaxial layer 21, as shown in Fig. 11(b). In case of liquid phase epitaxial growth from nearly saturated Ga solution, the difference between of the growth speeds on the horizontal face and on the step face is very large, and therefore the upper face of the epitaxial clad layer 21 becomes almost flat and horizontal all over the wafer. Then a diffusion mask of $Si_3N_4$ (not shown in the drawing) is formed on the epitaxial layer 21 and a 3 µm wide stripe-shaped opening is formed in a position where the center line of the stripe-shaped opening is offset from the center line of the stripe-shaped oblique central region 131 by 2 µm to the right (i.e. in the direction from the position of the step to the lower part). Then, from this opening of the mask, an acceptor such as Zn is selectively diffused in the stripe-shaped pattern from the surface of the epitaxial layer 21 to form a current injection region 22 of p-type conductivity. The depth of the diffusion is controlled so that the corner edge 221 of the current injection region 22 which is near the oblique central region 131 penetrates the epitaxial layer 21 and intrudes into the second clad layer 14 at the part approximately above the center line of the oblique central region 131, thereby forming an ohmic junction between the second clad layer 14 and current injection region 22. The condition of the diffusion is set 750°C for 20 minutes so as to attain a diffusion depth of 2.5 µm in order to form the current injection region as shown by Fig. 11(c). Since the second clad layer 14 has an oblique face at the part above the oblique central region 131 and the diffusion front of the current injection region 22 is vertical, the width of the ohmic junction can be easily controlled being as narrow as 3 µm or narrower by controlling the diffusion depth. Then, after removing the $Si_3N_4$ mask, the p-side electrode 23 is formed by sequential sputtering of Ti, Pt and Au. Thereafter, the bottom face of the substrate 11 is chemically etched so that the overall thickness of the wafer becomes 100 µm, and an n-side ohmic electrode 17 is formed by vapor deposition of Au-Ge-Ni followed by alloying treatment, as shown by Fig. 11(c). Then the laser wafer is divided into laser units by cleaving so that there are formed laser elements having a cavity length L of 250 µm and wafer width of 250 µm, and each element is mounted on a copper block.

A laser manufactured by the abovementioned process can lase at a low threshold current as 40 mA in the room temperature continuous wave oscillation and it attains a high external differential quantum efficiency ($\eta_{ext}$) of about 35%. The laser of Fig. 11(c) has the following advantageous features:

When a forward voltage is impressed across the positive electrode 23 and the negative electrode 17, a reverse bias voltage is impressed on the p-n junction between the n-type epitaxial layer 21 and the p-type second clad layer 14, and accordingly the injected current concentrates only to the current injection region 22 and flows through the narrow 3 µm wide ohmic junction part between the current injection region 22 and the second clad region 14. That is, the current injection region 22 is very narrow in its width and it is very close to the oblique central region 131 facing the central line of the latter. Therefore, the injected current necessarily concentrates in the central part of the lasing region, and thereby decreasing the threshold current of lasing and raising the external differential quantum efficiency $\eta_{ext}$, and furthermore, parasitic oscillations due to spread current are suppressed.

Since the second clad layer 14 has its thicker part only above the oblique central region 131, i.e., the lasing region, and the part adjacent to the thicker part is formed thin, transverse spreading of the injected current to the thin adjacent part is efficiently suppressed and current is injected substantially only to the oblique central region 131.

The light oscillations in the oblique central region 131 are sufficiently confined therein by means of both thick parts of the clad layers 12 and 14 disposed on both sides of the oblique central region 131, and the two bendings of the active layer 13, thereby assuring very efficient single mode oscillations.

The concentration of injected current to the central line part of the oblique central region 131 and the good confinement of the light in the oblique central region 131 result in a drastic reduction of the threshold current and the internal quantum efficiency $\eta_{int}$. Fig. 11(d) to Fig. 11(h) show various characteristics of the laser of Fig. 11(c) having a cavity length of L=250 µm. In Fig. 11(d), small circles show experimental values of wavelength-threshold current characteristics at room temperature continuous wave lasing, and the dashed curve shows the inverse of the internal quantum efficiency $\eta_{int}$ obtained by a calculation based on a threshold current of 20 mA for the oscillation wavelength of 850 nm. The experimental values and the calculated curve shows a good agreement. It is supposed that the increase of the threshold current to shorter wavelengths is due to the decrease of $\eta_{int}$. However, by the good confinement of current in the lasing region, the threshold current takes low values even for the visible light, e.g.:

30—50 mA ... at λ=730 nm and
90 mA ... at λ=710 nm.

Fig. 11(e) shows the light output—current characteristic of the laser for the lasing wavelengths of λ=830 nm and λ=725 nm, and their far field image of the light. The laser of λ=830 nm has the fundamental mode oscillation up to a current twice the threshold current. The maximum output (to break the end face) of this laser was 30 mW without the end protection film, and 50 mW with the end protection film. It was confirmed that when the laser was oscillating in the fundamental transverse mode the oscillation spectrum was a single axial mode.

Fig. 11(f) shows light output—current characteristics of the laser of λ=731 nm for variations of the ambient temperature. The maximum temperature at which continuous oscillation is possible decreases with shorter wavelengths, as follows:

150°C ... for the laser of 830 nm, and
110°C ... for the laser of 730 nm.

Fig. 11(g) shows the temperature dependence of the threshold current $I_{th}$ for the lasers of 733 nm, 758 nm and 782 nm. In Fig. 11(g), the figures $T_{01}$ and $T_{02}$ are obtained by a formula:

$$I_{th} \propto \exp\ (T/T_{0l})$$

Every laser shown by Fig. 11(g) has higher characteristic temperatures $T_{01}$ and lower characteristics temperatures $T_{02}$ bounded by critical temperatures $T_c$.

Fig. 11(h) shows lifetime characteristics of the laser of Fig. 11(c), measured in a 25°C $N_2$ atmosphere, operating to output 4 mW continuous wave by means of an automatic power control system. The end faces of the laser were not coated. As shown by the curves, the lifetimes become shorter with shorter oscillation wavelengths, e.g. for the wavelength of λ=726 nm the lifetime is about 150 hrs. As a result of a high temperature accelerated lifetest, the lifetime of this laser can be expected to be longer than $2 \times 10^5$ hours for infrared wavelength oscillations and a similar lifetime can also be expected for the oscillation of 760 nm or longer wavelengths.

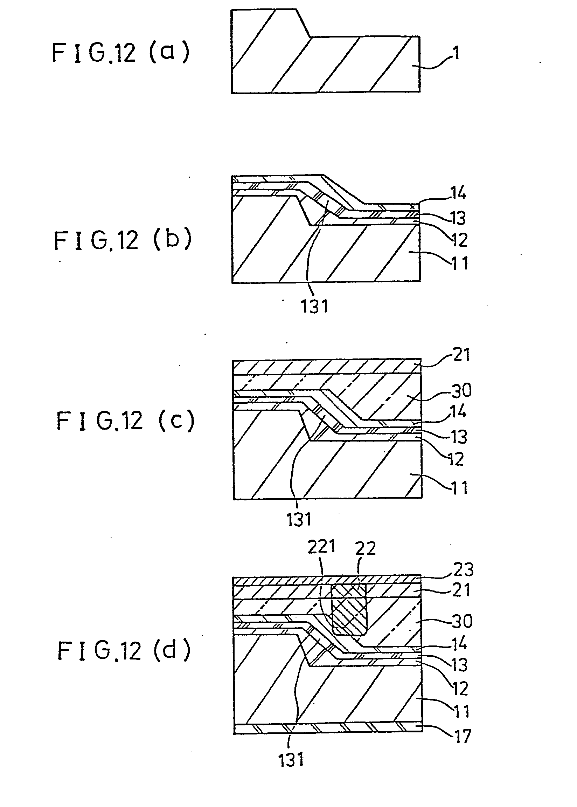

Fig. 12(a), Fig. 12(b), Fig. 12(c) and Fig. 12(d) show steps of manufacturing another example of the laser according to the invention, which is capable of good current confining. This laser has an additional layer 30 of n-$Ga_{1-z}Al_z$as which can effectively confine the light therein between a second clad layer 14 of $Ga_{1-x}Al_xAs$ and an epitaxial layer 21 of n-GaAs. In Fig. 12(a), there is shown

a terraced substrate 11 of ... n-GaAs having a terrace step T which is about 1.5 μm high thereon the following layers are formed by a sequential liquid phase epitaxial growth:

a first clad layer 12 of ... n-$Ga_{1-x}Al_xAs$,
an active layer 13 of ... n-$Ga_{1-y}Al_yAs$,
a second clad layer 14 of ... p-$Ga_{1-x}Al_xAs$,
a third clad layer 30 of ... n-$Ga_{1-z}Al_zAs$,
an epitaxial layer 21 of ... p-GaAs.

The terraced-shape semiconductor substrate is formed to have a step T, and on its surface, the first clad layer 12 of n-GaAlAs is formed by a liquid phase epitaxial growth method, in such a manner that at the parts above the thinner and thicker horizontal parts of the substrate 11 the first clad layer 12 is formed about 0.3 μm thick so as to allow transmission of evanescent light from the overlying active layer 13 to the substrate 11, and that at the part above the foot of the step part T the first clad layer 12 is formed about 1 μm thick so as to prevent the transmission of evanescent light from the active layer 13 to the substrate 11 therethrough. Such a thickness can be obtained as a result of the growth rate being higher at the step part. Subsequently, the active layer 13 of non-doped $Ga_{0.95}Al_{0.05}As$ is epitaxially grown on the first clad layer 12 so that the oblique central part 13 of the active layer 13 is defined between the upper bending and the lower bending, and that the oblique central region 131 is about 0.1 μm thick and thus is thicker than horizontal parts of the active layer 13 which are about 0.08 μm thick. Subsequently, the second clad layer 14 of p-$Ga_{0.65}Al_{0.35}As$ is epitaxially grown as is shown in Fig. 12(b), in such a manner that it is about 0.4 μm thick at the horizontal parts and about 1.5 μm thick at the oblique part which is above the oblique central region 131 in order to prevent transmission of evanescent light from the oblique central region 131 of the active layer 13 to the overlying layers. Then the third clad layer 30 and the epitaxial layer 21 are formed by sequential liquid phase epitaxial growth from nearly saturated Gas solutions as shown by Fig. 12(c). The clad layers 14 and 30 are of opposite conductivity types, and they have broader energy gaps than the active layer 13. One example of the values of x, y and z for infrared lasers is:

x=0.35,
y=0.05 and
z=0.35 or smaller.

As a result of the abovementioned use of the nearly saturated Ga solution, by means of a large difference of the growth speeds on the horizontal face and on the oblique face near the step part, the third clad layer 30 becomes thicker (about 2.5 μm) on the lower horizontal part of the active layer 13 and thinner (about 1 μm) on the higher horizontal part of the active layer 13, thereby forming a substantially flat and horizontal junction face between the third clad layer 30 and the epitaxial layer 21, as shown in Fig. 12(c). Then a diffusion mask of $SiO_2$ or $Si_3N_4$ (not shown in the drawing) is formed on the epitaxial layer 21 and a 3 μm wide stripe-shaped opening is formed in a position where the center line of the stripe-shaped opening is offset from the center line of the stripe-shaped oblique central region 131 by 2 μm to the right (i.e. in the direction from the position of the step to the lower part). Then, from this opening of the mask, an acceptor such as Zn is selectively diffused in the stripe-shaped pattern from the surface of the epitaxial layer 21 to form a current injection region 22 of p-type conductivity. The width of the ohmic junction between the current injection region 22 and the second clad layer 14 can be easily controlled so that it is smaller than the width of the current injection region 22 by controlling the position and the depth of the current injection region 22. The diffusion of the region 22 should be stopped so as to retain the other corner edge of the current injection region 22 in the epitaxial layer 21. Then, the p-side electrode 23 and the n-side electrode 17 are formed on the upper and lower faces of the wafer as shown by Fig. 12(d).

In accordance with the structure of this example of Fig. 12(d), by means of the provision of the third clad layer 30 of GaAlAs, which shows a smaller light transmission than the epitaxial layer 21 of GaAs, there is not to be feared that the light is transmitted upwards. Accordingly, the second clad layer 14 can be thin on the oblique central region 131. Therefore, because of such thinness of the clad layer 14 on the oblique central region 131, the satisfactory confinement of the injected current in the oblique central region, or the satisfactory suppressing of lateral spreading of the injected current can be attained, thereby enabling highly the concentration of the injected current to the lasing region and reducing the threshold current. This laser can oscillate with a current of only 20 mA and has a high efficiency issuing light with an output of 10 mW or more with the injected current being 20 Ma to 30 mA. Also, the linearity between the injected current and the light output is good over a wide range so that a light output of 50 MW or more can be obtained with good linearity.

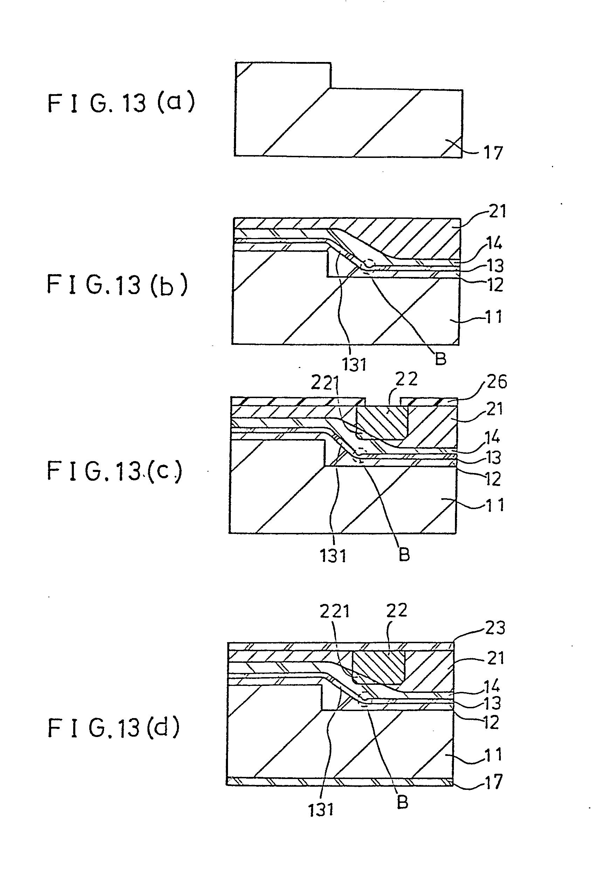

Fig. 13(a), Fig. 13(b), Fig. 13(c) and Fig. 13(d) shows steps of manufacturing another example of the laser of still according to the invention which has very thin parts at both bendings of the active layer 13 and is hence capable of a very low threshold current and a very small far-field spot characteristic.

On a substrate as shown in Fig. 13(a), i.e. on a terraced substrate 11 of ... n-GaAs having a terrace step T which is about 2 μm high, the following layers are formed by a sequential liquid phase epitaxial growth:

a first clad layer 12 of ... $n-Ga_{0.7}Al_{0.3}As$,
an active layer 13 of ... $n-Ga_{0.95}Al_{0.05}As$
a second clad layer 14 of ... $p-Ga_{0.7}Al_{0.3}As$,
an epitaxial layer 21 of ... n-GaAs,

as shown by Fig. 13(b).

The manufacture of the GaAs/$Ga_{1-x}Al_xAs$ laser of Fig. 13(a) to Fig. 13(d) is elucidated in detail in the following: A step of 2 μm height in the <011> direction is formed on the (100) face of an n-GaAs substrate 11 by a known photolithographic technique utilizing an etchant containing sulfuric acid. Then by means of a liquid phase epitaxial growth method, a first clad layer 12 of n-$Ga_{0.7}Al_{0.3}As$ is formed in such a manner that at the parts above the thinner and the thicker horizontal parts of the substrate 11, the first clad layer 12 is formed of about 1 μm thick. Subsequently, the active layer 13 of non-doped $Ga_{0.95}Al_{0.05}As$ is epitaxially grown on the first clad layer 12 so that the active layer 13 has the oblique central part 131 being defined between an upper bending and a lower bending and that at least the lower bending is thinned to be about 0.08 μm thick, so that the bending part is thinner than other parts of the active layer 13. Subsequently, the second clad layer 14 of $p-Ga_{0.65}Al_{0.35}As$ is epitaxially grown, in such a manner that it is about 0.4 μm thick at the horizontal parts and about 1.0 μm thick at the oblique part which is above the oblique central region 131. Subsequently the epitaxial layer 21 of n-GaAs is epitaxially grown in such a manner that it is about 2.5 μm above the lower horizontal part of the active layer 13 and about 1 μm above the higher horizontal part of the active layer 13, thereby forming a flat and horizontal upper face thereof. In case of liquid phase epitaxial growth from nearly saturated Ga solution, the difference of the growth speeds on the horizontal face and on the step face is very large, and therefore the upper face of the epitaxial layer 21 becomes almost flat and horizontal all over the wafer. Then a diffusion mask of $Si_3N_4$ (not shown in the drawing) is formed on the epitaxial layer 21 and a 3 μm wide stripe-shaped opening is formed in a position where the center line of the stripe-shaped opening is offset from the center line of the stripe-shaped oblique central region 131 by 2 μm to the right (i.e. in the direction from the position of the step to the lower part). Then, from this opening of the mask, an acceptor such as Zn is selectively diffused in the stripe-shaped pattern from the surface of the epitaxial layer 21 to form a current injection region 22 of p-type conductivity. The depth of the diffusion is so controlled so that the corner edge 221 of the current injection region 22 which is near the oblique central region 131 penetrates the epitaxial layer 21 and intrudes into the second clad layer 14 at the part approximately above the center line of the oblique central region 131, thereby forming an ohmic junction between the second clad layer 14 and the current injection region 22, as is shown in Fig. 13(c). Since the second clad layer 14 has an oblique face at the part above the oblique central region 131 and the diffusion front of the oblique central region 22 slopes down vertically, the width of the ohmic junction can be easily controlled to be as narrow as 3 μm or narrower by controlling the diffusion depth. Then, after removing the $Si_3N_4$ mask, the p-side electrode 23 is formed by sequential sputtering of Ti, Pt and Au. Thereafter, the bottom face of the substrate 11 is chemically etched so that the overall thickness of the wafer becomes 100 μm, and an n-side ohmic electrode 17 is formed by vapor deposition of Au-Ge-Ni followed by alloying treatment, as is shown by Fig. 13(d). Then the laser wafer is divided into laser units by cleaving so that there are formed laser elements having a cavity length L of 250 μm and a wafer width of 250 μm, and each element is mounted on a copper block.

The laser manufactured by the abovementioned process can lase at a low threshold current Ith of 30 mA to 40 mA in the room temperature continuous wave oscillation and attains a high external differential quantum

efficiency ($\eta_{ext}$) of about 40%. The laser of Fig. 13(d) has the following advantageous features:

When a forward voltage is impressed across the positive electrode 23 and the negative electrode 17, a reverse bias voltage is impressed on the p-n junction between the n-type epitaxial layer 21 and the p-type second clad layer 14, and accordingly the injected current concentrates only on the current injection region 22 and flows through the narrow 3 µm wide ohmic junction part between the current injection region 22 and the second clad region 14. That is, the current injection region 22 is very narrow in its width and it is very close to the oblique central region 131 facing the central line of the latter. Furthermore, from the lower end of the lasing the injected current necessarily concentrates in the central part of the oblique central region 131 and the light is sufficiently confined in the oblique central region 131. Therefore, by the interaction of the improvements in the current concentration and in the light confinement, the threshold current of the lasing is drastically decreased, and the external differential quantum efficiency $\eta_{ext}$ is also much improved, and furthermore, the parasitic oscillation due to spread current is suppressed.

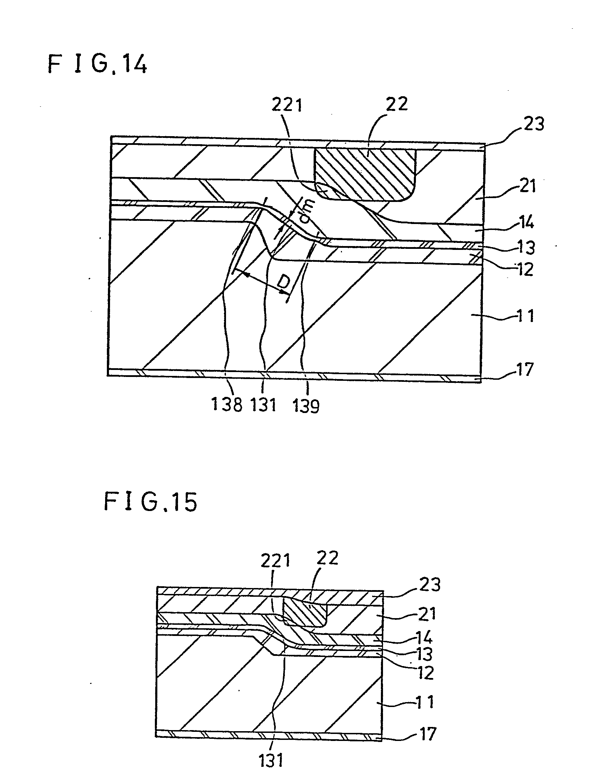

Fig. 14 shows still another example having a lasing region of lens-like section and thereby having a very high external differential quantum efficiency. The structure of this laser is: on a terraced substrate 11 of ... n-GaAs having a terrace step T, which is 1.5 to 2.0 µm high the following layers are formed by a sequential liquid phase epitaxial growth:

a first clad layer 12 of ... n-Ga$_{0.7}$Al$_{0.3}$As.
an active layer 13 of ... n-Ga$_{0.95}$Al$_{0.05}$As,
a second clad layer 14 of ... p-Ga$_{0.7}$Al$_{0.3}$As,
an epitaxial layer 21 of ... n-GaAs,

as shown by Fig. 14. The manufacture of the GaAs/Ga$_{1-x}$Al$_x$As laser will be described in detail in the following. A step of 1.5 to 2.0 µm height in the <011> direction is formed on the (100) face of an n-GaAs substrate 11 by a known photolithographic technique utilizing an etchant containing sulfuric acid. Then by means of a liquid phase epitaxial growth method, a first clad layer 12 of n-Ga$_{0.7}$Al$_{0.3}$As is formed in such a manner that at the parts above the thinner and the thicker horizontal parts of the substrate 11 the first clad layer 12 is about 0.4 µm thick and that at the part above the foot of the step part T, the first clad layer 12 is about 1 µm thick. The epitaxial growth of the first clad layer 12 is started at 845°C, the cooling rate is 0.3°C/minute and the growth of the first clad layer 12 is stopped at the temperature of 843°C so that the thickness of 1 µm is obtained on the foot of the step part T.

Subsequently, the active layer 13 of non-doped Ga$_{0.95}$Al$_{0.05}$As is epitaxially grown on the first clad layer 12 so that the layer has the oblique central region 131 being defined between the upper bending and the lower bending and that the oblique central region 131 is shaped so that it has a convex lens-like section defined between a very thin upper bending 138 and a very thin lower bending 139. Such a sectional shape is obtained by controlling the supercooling temperature to be 6—8°C and the growth time to be 0.6 sec. The preferable width D and the maximum thickness dm of the oblique central region 131 depend on the difference of the refractive indexes of the active layer 13 and of the clad layers 12 and 14; in this example, D≒3.5 µm and dm=0.1 µm. Subsequently, the second clad layer 14 of p-Ga$_{0.65}$Al$_{0.35}$As is epitaxially grown in such a manner that it is about 0.4 µm thick at the horizontal parts and about 1.5 µm thick at the oblique part which is lying on the oblique central region 131. The second clad layer is formed so as to have a thick part on the oblique central region 131, by growing it from a nearly saturated Ga-solution. Subsequently the epitaxial layer 21 of n-GaAs is epitaxially grown in such a manner that it is about 2.5 µm on the lower horizontal part of the active layer 13 and about 1 µm on the higher horizontal part of the active layer 13, thereby having a flat and horizontal upper face as shown in Fig. 14. Such a forming with different thickness is also attained by growth from a nearly saturated Ga-solution. Then, by use of a known mask of SiO$_2$ or Si$_3$N$_4$ an acceptor such as Zn is selectively diffused in a 3 µm wide stripe-shaped pattern from the surface of the epitaxial layer 21 in order to form a current injection region 22 of p-type conductivity.

Then, after removing the Si$_3$N$_4$ mask the p-side electrode 23 is formed by sequential sputtering of Ti, Pt and Au. Thereafter, the bottom face of the substrate 11 is chemically etched so that the overall thickness of the wafer becomes 100 µm, and an n-side ohmic electrode 17 is formed by vapor deposition of Au-Ge-Ni followed by alloying treatment.

The laser manufactured by the abovementioned process is very much improved in the threshold current and the external differential quantum efficiency, and lasing at a fundamental transverse mode is obtainable up to such a large current which is 3 times large as the threshold current. This example of the laser having a cavity length L=250 µm can lase at such a low threshold current as 25 mA in room temperature continuous wave oscillations and it attains a high external differential quantum efficiency ($\eta_{ext}$) of about 40%. In this laser of Fig. 14, the distribution of the effective refractive index is formed as a parabolic distribution having the peak at the centre of the oblique central region 131, and therefore a large width D can be selected. This yields the advantage of making the above process easy and of facilitating cutting off higher modes of oscillation.

Fig. 15 shows still another example having an oblique central region 131 which has smooth bendings on both side parts. The structure of this laser is follow on a terraced substrate 11 of ... n-GaAs having a terrace step T which is about 2 µm high the following layers are formed by a sequential liquid phase epitaxial growth:

a first clad layer 12 of ... n-Ga$_{0.7}$Al$_{0.3}$As

an active layer 13 of ... n-$Ga_{0.95}Al_{0.05}As$,
a second clad layer 14 of ... p-$Ga_{0.7}Al_{0.3}As$,
an epitaxial layer 21 of ... n-GaAs,
as shown by Fig. 15. The manufacture of the GaAs/$Ga_{1-x}Al_xAs$ laser of Fig. 15 is elucidated in detail in the following. A step of 1.5 μm height in the <011> direction is formed on the (100) face of an n-GaAs substrate 11 by a known photolithographic technique by utilizing an etchant containing sulfuric acid. Then by means of a liquid phase epitaxial growth method, a first clad layer 12 of n-$Ga_{0.7}Al_{0.3}As$ is formed in such a manner that at the parts above the thinner and the thicker horizontal parts of the substrate 11 the first clad layer 12 is about 0.2 μm thick and that at the part above the foot of the step part T, the first clad layer 12 is about 1 μm thick. The epitaxial growth of the first clad layer 12 is started at 845°C, the cooling rate is 0.3°C/minute and the growth of the first clad layer 12 is stopped at the temperature of 843°C so that the thickness of 1 μm is obtained on the foot of the step part T. Subsequently the active layer 13 of non-doped $Ga_{0.95}Al_{0.05}As$ is epitaxially grown on the first clad layer, so that the layer has the oblique central region 131 being defined between two smoothly curved bendings and that the oblique central region 131 has a uniform thickness of about 0.1 μm. In order to attain the abovementioned condition of growth, it is empirically found that the initial supercooling temperature should be 6—8°C. Subsequently, the second clad layer 14 of p-GaAlAs is epitaxially grown, in such a manner that it is about 0.4 μm thick at the horizontal parts and about 1.5 μm thick at the oblique part which is on the oblique central region 131. Subsequently the epitaxial layer 21 of n-GaAs is epitaxially grown in such a manner that it is about 2.5 μm thick on the higher horizontal part of the active layer 13, thereby forming a flat and horizontal upper face as shown in Fig. 15. Such a forming with different thickness is attained by the growth from a nearly saturated Ga-solution. Then, by use of a known mask of $SiO_2$ or $Si_3N_4$, an acceptor such as Zn is selectively diffused in a 3 μm wide stripe-shaped pattern from the surface of the epitaxial layer 21 in order to form a current injection region 22 of p-type conductivity.

Then, after removing the $Si_3N_4$ mask the p-side electrode 23 is formed by sequential sputtering of Ti, Pt and Au. Thereafter, the bottom face of the substrate 11 is chemically etched so that the overall thickness of the wafer becomes 100 μm, and an n-side ohmic electrode 17 is formed by vapor deposition of Au-Ge-Ni followed by an alloying treatment. The laser manufactured by the abovementioned process has such a stable lasing characteristic that with a width D=5 μm of lasing region, it can oscillate at a fundamental transverse mode continuous wave up to a large current which is 3 times as large as the threshold current in the room temperature.

In the laser of Fig. 15, there are no clear bendings between the oblique lasing region 131 and the neighboring horizontal regions of the active layer 13. Accordingly, the difference of the refractive indexes between the oblique central region 131 and other parts of the active layer 13 is induced only by the corresponding difference of the first clad layer. Therefore, the difference of the refractive index is very small being of the order of magnitude of $10^{-3}$. Accordingly, even when the width between two bendings is extended to be about 5 μm, there is no fear of inducing higher modes of oscillation, and hence a stable single fundamental transverse mode oscillation is possible.

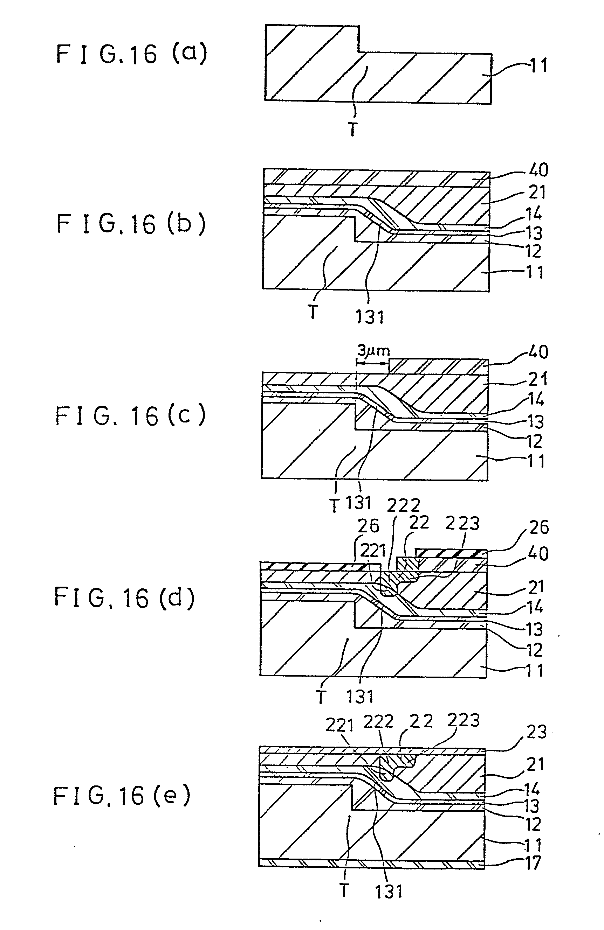

Fig. 16(a) to Fig. 16(e), Fig. 17(a) to Fig. 17(b) and Fig. 18(a) to Fig. 18(b) show examples of the manufacturing method which are suitable for manufacturing the lasers shown in Fig. 10 to Fig. 15.

Fig. 16(a) to Fig. 16(e) show a manufacturing process of a laser with the following structure on a terraced substrate 11 of ... n-GaAs having a terrace step T which is 1.5 μm high the following layers are formed by a sequential liquid phase epitaxial growth:
a first clad layer 12 of ... n-$Ga_{0.7}Al_{0.3}As$,
an active layer 13 of ... n-$Ga_{0.95}Al_{0.05}As$,
a second clad layer 14 of ... p-$Ga_{0.7}Al_{0.3}As$,
an epitaxial layer 21 of ... n-GaAs,
an additional epitaxial layer 40 of ... n-$Ga_{0.35}Al_{0.65}As$.
as shown by Fig. 16(b).

A step of 1.5 μm height in the <011>direction is formed on the (100) face of an n-GaAs substrate 11 by a known photolithographic technique by utilizing an etchant containing sulfuric acid. Then by means of a liquid phase epitaxial growth method, a first clad layer 12 of n-$Ga_{0.7}Al_{0.3}As$ is formed, in such a manner that at the parts above the thinner and thicker horizontal parts of the substrate 11 the first clad layer 12 is formed about 0.2 μm thick and that, at the part above the foot of the step part T, the first clad layer 12 is formed about 1 μm thick. Such a thickness can be obtained in consequence of the growth rate being higher at the step part. Subsequently, the active layer 13 of non-doped $Ga_{0.95}Al_{0.05}As$ is epitaxially grown on the first clad layer 12, so that the active layer 13 has the oblique central part 131 being defined between the upper bending and the lower bending, and that the oblique central region 131 is about 0.1 μm thick and thus is thicker than the horizontal parts of the active layer 13 which are about 0.08 μm thick. Subsequently, the second clad layer 14 of p-$Ga_{0.65}Al_{0.35}As$ is epitaxially grown in such a manner that it is about 0.4 μm thick at the horizontal parts and about 1.5 μm thick at the oblique part which is above the oblique central region 131. Subsequently the epitaxial layer 21 of n-GaAs is epitaxially grown in such a manner that it is about 2.5 μm on the lower horizontal part of the active layer 13 and about 1 μm on the higher horizontal part of ths active layer 13, thereby having a p-n isolation junction with two bendings between the active layer 14 and the epitaxial layer 21. Then, an additional epitaxial layer 40 of n-$Ga_{0.35}Al_{0.65}As$ is sequentially grown to a thickness 1.5 µm as shown in Fig. 16(b). Then, the additional epitaxial layer 40 is selectively removed from the part around above the central line of the oblique central region 131 and the part above the end of the thicker part of the substrate 11, as is shown in Fig. 16(c). That is, the gap between the selectively etched end of the additional epitaxial layer 40 and the step of the substrate is selected to be 3 µm. Then, a diffusion mask 26 of $Si_3N_4$ is formed over the epitaxial layer 21 and a 5 µm width stripe-shaped opening is formed in a position as shown in Fig. 16(d), exposing the upper face of the epitaxial layer 21 by 2 µm. Then an acceptor such as Zn is selectively diffused, in the stripe-shaped pattern from the surface of the epitaxial layer 21 in order to form a current injection region 22 of p-type conductivity. The depth of the diffusion is controlled in such a manner that the corner edge 221 of the current injection region 22 which is near the oblique central region 131 penetrates the epitaxial layer 21 and intrudes into the second clad layer 14 at the part approximately above the center line of the oblique central region 131, thereby forming an ohmic junction between the second clad layer 14 and the current injection region 22. The current injection region 22 formed thereby is shown in Fig. 16(d). Thereafter the diffusion mask 26 and the additional epitaxial layer 40 are removed and the p-side electrode 23 is formed by sequential sputtering of Ti, Pt and Au. Thereafter, the bottom face of the substrate 11 is chemically etched so that the overall thickness of the wafer becomes 100 µm, and an n-side ohmic electrode 17 is formed by vapor deposition of Au-GeNi followed by an alloying treatment, as shown by Fig. 16(e).

The laser manufactured by the abovementioned process can lase at a threshold current as low as 40 mA in room temperature continuous wave oscillation and it attains a high external differential quantum efficiency ($\eta_{ext}$) of about 35%.

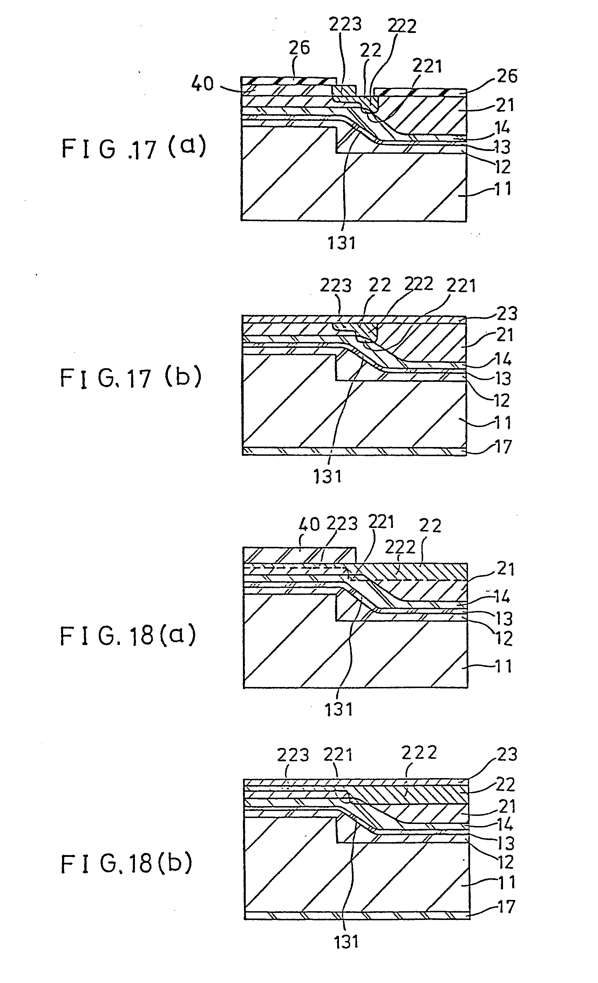

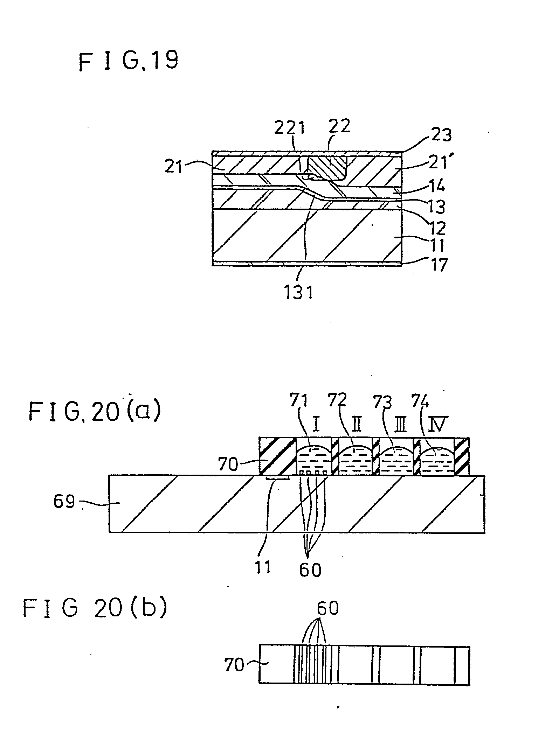

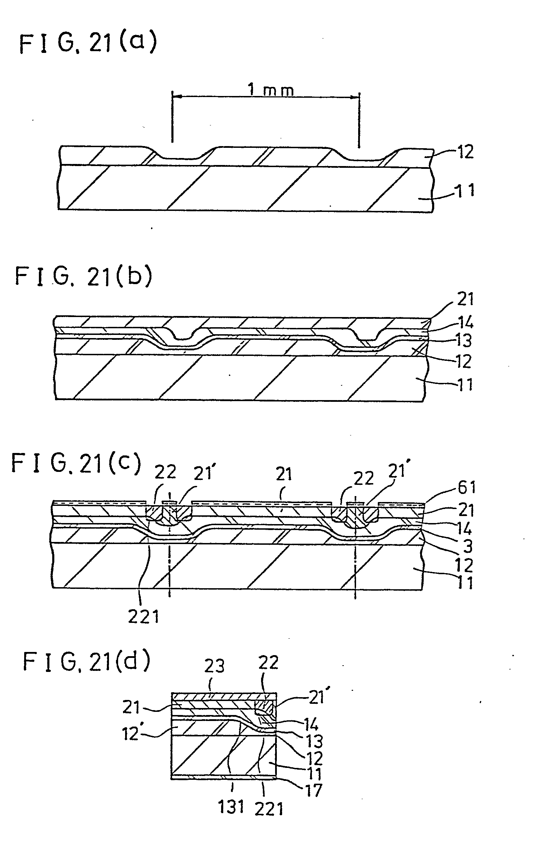

Fig. 17(a) and 18(b) show a variation step to follow the step of Fig. 16(b). That is, after forming the epitaxial growth as Fig. 16(b), the additional layer 40 is etched as shown by Fig. 17(a) followed by diffusion for forming the current injection region 22 as shown by Fig. 17(b). And the laser is similarly completed by removing the mask 26 and the additional layer 40, followed by forming the electrodes 23 and 17.

Fig. 18(a) and Fig. 18(b) show another variation following the step of Fig. 16(b). That is, instead of forming the mask, the acceptor Zn is diffused on all the face of the wafer, so that the current injection region 22 is formed in the shape as shown in Fig. 18(b). Thereafter, by removing the additional layer 40 and forming electrodes 23 and 17, the laser of Fig. 18(b) is completed.

In the examples of Figs. 16(e), 17(b) and 18(b), the narrow current injection regions 221 are easily formed by using the additionally epitaxial grown layer 40 as a mask, and therefore a laser of small threshold current and good light confinement is easily obtained with comparably few number of steps.

## Claims

1. a semiconductor laser comprising
a terraced-shape semiconductor substrate (11) having a thinner part and a thicker part with a step (T) inbetween,
a first semiconductor clad layer (12) formed on said substrate and having a lower part formed on said thinner part, an upper part formed on said thicker part and a central part formed to connect said lower part and said upper part and having an oblique upper face with respect to the principal face of said substrate and having a larger thickness than those of the lower part and the upper part,
an active semiconductor layer (13) formed on said first clad layer and having a horizontal lower part formed on said lower part of the first clad layer, a horizontal upper part formed on said upper part of the first clad layer and an oblique central region (131) as a lasing region formed on said central part of said first clad layer and connecting said horizontal lower part and said horizontal upper part therewith with a lower bending and an upper bending inbetween, and
a second semiconductor clad layer (14) formed on said active layer,
characterized in that
a current injection region (22) of a stripe-shaped pattern is formed contacting said second clad layer at a part above said oblique central region of the active layer and thereby forming an ohmic junction with the second clad layer, the junction having a width which is smaller than or at the most equal to the width of said oblique central region.

2. A semiconductor laser in accordance with claim 1, wherein a width of said current injection region (22) is smaller than a width in plan view of said oblique central region (131).

3. A semiconductor laser in accordance with claim 1, which further comprises
an epitaxial semiconductor layer (21) which is disposed immediately on said second clad layer (14) and has an opposite conductivity type to said second clad layer, and said current injection region (22) extends through said epitaxial layer and has the same conductivity type as said second clad layer.

4. A semiconductor laser in accordance with claim 1, wherein said oblique central region (131) of said active layer (13) has a sectional of a shape of a section of a convex lens.

5. A semiconductor laser in accordance with claim 1, wherein said second clad layer (14) has a step shaped upper face.

6. A semiconductor laser in accordance with claim 1, wherein said lower bending and upper bending of said active layer (13) have smooth curvature.

7. A semiconductor laser in accordance with claim 1, wherein at least one of said lower bending part and said upper bending part of said active layer (13) is thinner than other parts of said active layer.

8. A semiconductor laser in accordance with claim 1, wherein said oblique central region (131) is formed obliquely with respect to the face of said thinner part of said substrate over a part of said step of said substrate (11).

9. A semiconductor laser in accordance with claim 1 swherein said semiconductor substrate (11), active layer (13) and clad layers (12, 14) are of III—V compound semiconductor.

10. A semiconductor laser in accordance with claim 1, wherein specific resistivity of said second clad layer (14) is $10^{-2}\Omega \cdot cm$ or higher.

11. A semiconductor laser in accordance with claim 1, wherein said second clad layer (14) has an oblique part on said oblique central region (131) of said active layer (13), and in said second clad layer said oblique part is thicker than other parts of said second clad layer.

12. A semiconductor laser in accordance with claim 3, wherein the upper face of said second clad layer (14) has an oblique part above said oblique central region (131), wherein said current injection region (22) contacts.

13. A semiconductor laser in accordance with claim 3, wherein said epitaxial layer consists of two layers (21, 40) of the same conductivity type.

14. A semiconductor laser in accordance with claim 3, wherein a junction between said second clad layer (14) and said epitaxial layer (21) has a bending part above said bending of the active layer (13) and a lower corner edge (221) of said current injection region (22) which is nearer to said oblique central region (131) intrudes through said junction into said second clad layer and other lower corner edge remains in said epitaxial layer.

15. A semiconductor laser in accordance with claim 3, wherein said current injection region (22) is a Zn diffused region.

**Patentansprüche**

1. Halbleiterlaser, mit

einem terrassenförmigen Halbleitersubstrat (11), welches einen dünneren Teil und einen dickeren Teil mit einer Stufe (T) dazwischen hat,

einer ersten Halbleiterauflageschicht (12), die an dem genannten Substrat gebildet ist und einen an dem genannten dünneren Teil gebildeten unteren Teil, einen an dem genannten dickeren Teil gebildeten oberen Teil und einen mittleren Teil aufweist, der gebildet ist, um den genannten unteren Teil und den genannten oberen Teil zu verbinden, und der mit Bezug auf die Hauptfläche des genannten Substrats eine schräge obere Fläche und eine Dicke hat, die größer als die Dicke des unteren Teiles und des oberen Teiles ist,

einer aktiven Halbleiterschicht (13), die an der ersten Auflageschicht gebildet ist und einen horizontalen unteren Teil, der an dem unteren Teil der ersten Auflageschicht gebildet ist, einen horizontalen oberen Teil, der an dem oberen Teil der ersten Auflageschicht gebildet, ist, und

einen schrägen mittleren Bereich (131) als den Laserstrahlbildungsbereich hat, der an dem genannten mittleren Teil der genannten ersten Auflageschicht gebildet ist und den genannten horizontalen unteren Teil und den genannten horizontalen oberen Teil damit verbindet mit einer unteren Biegung une einer oberen Beigung dazwischen, und

einer zweiten Halbleiterauflageschicht (14), die an der genannten aktiven Schicht gebildet ist, dadurch gekennzeichnet, daß

ein Strominjektionsbereich (22) eines streifenförmigen Musters gebildet ist, der in die genannte zweite Auflageschicht eindringt, um die letztere an einem Teil über dem genannten schrägen mittleren Bereich der aktiven Schicht zu kontaktieren, wodurch ein Ohm'scher Übergang mit der zweiten Auflageschicht gebildet ist, und der Übergang eine Breite hat, die gleich oder kleiner als eine Breite des genannten schrägen mittleren Bereiches ist.

2. Halbleiterlaser nach Anspruch 1, bei welchem eine Breite des genannten Strominjektionsbereiches (22) kleiner ist als eine Breite in Draufsicht des genannten schrägen mittleren Bereiches (131).

3. Halbleiterlaser nach Anspruch 1, der weiterhin aufweist,

eine epitaxiale Halbleiterschicht (21), die unmittelbar an der genannten zweiten Auflageschicht (14) angeordnet ist und einen zu der genannten zweiten Auflageschicht entgegengesetzten Leitfähigkeitstyp hat, und der genannten Strominjektionsbereich (22) sich durch die genannten epitaxiale Schicht erstreckt und den gleichen Leitfähigkeitstyp wie die genannte zweite Auflageschicht hat.

4. Halbleiterlaser nach Anspruch 1, bei welchem der genannte schräge mittlere Bereich (131) der genannten aktiven Schicht (13) einen Teilabschnitt einer Gestalt eines Abschnittes oder Querschnittes einer konvexen Linse hat.

5. Halbleiterlaser nach Anspruch 1, bei welchem die genannte zweite Auflageschicht (14) eine stufenförmige obere Fläche hat.

6. Halbleiterlaser nach Anspruch 1, bei welchem die genannte untere Biegung und die obere Biegung der genannten aktiven Schicht (13) eine glatte Krümmung haben.

7. Halbleiterlaser nach Anspruch 1, bei welchem wenigstens der genannte untere Biegungsteil oder der genannte ober Biegungsteil der genannten aktiven Schicht (13) dünner als andere Teile der genannten aktiven Schicht ist.

8. Halbleiterlaser nach Anspruch 1, bei welchem der genannte schräge mittlere Bereich (131) schräg gebildet ist mit Bezug zu der Fläche des genannten dünneren Teiles des Substrates über einem Teil der genannten Stufe des genannten Substrates (11).

9. Halbleiterlaser nach Anspruch 1, bei welchem das genannte Halbleitersubstrat (11) die aktive Schicht (13) und die Auflageschichten (12, 14) aus III—V Verbindungshalbleitern bestehen.

10. Halbleiterlaser nach Anspruch 1, bei welchem der spezifische Widerstand der genannten zweiten Auflageschicht (14) 10⁻²Ω·cm oder höher ist.

11. Halbleiterlaser nach Anspruch 1, bei welchem die genannte zweite Auflageschicht (14) einen schrägen Teil an dem genannten schrägen mittleren Bereich (131) der genannten aktiven Schicht (13) hat und in der genannten zweiten Auflageschicht der genannte schräge Teil dicker als andere Teile der genannten zweiten Auflageschicht ist.

12. Halbleiterlaser nach Anspruch 3, bei welchem die obere Fläche der genannten zweiten Auflageschicht (14) einen schrägen Teil über dem genannten schrägen mittleren Bereich (131) hat, in welchem der genannte Strominjektionsbereich (22) kontaktiert.

13. Halbleiterlaser nach Anspruch 3, bei welchem die epitaxiale Schicht aus zwei Schichten (21, 40) des gleichen Leitfähigkeitstyps besteht.

14. Halbleiterlaser nach Anspruch 3, bei welchem ein Übergang zwischen der genannten zweiten Auflageschicht (14) und der genannten epitaxialen Schicht (21) einen Biegeteil über der genannten Biegung der aktiven Schicht (13) hat und eine untere Eckkante (221) des genannten Strominjektionsbereiches (22), die gem genannten schrägten mittleren Bereich (131) näher liegt, durch den genannten Übergang hindurch in die genannte zweite Auflageschicht eindringt und die andere untere Eckkante in der genannten epitaxialen Schicht verbleibt.

15. Halbleiterlaser nach Anspruch 3, bei welchem der Strominjektionsbereich (22) ein Zn diffundierter Bereich ist.

## Revendications

1. Laser à semi-conducteur comprenant:

— un substrat (11) en semi-conducteur en forme de terrasse comportant une partie fine et une partie épaisse avec entre elles un gradin (T),
— une première couche (12) de revêtement en semi-conducteur formée sur le substrat et présentant une partie inférieure formée sur la partie fine, une partie supérieure formée sur la partie épaisse et une partie centrale formée de manière à relier la partie inférieure et la partie supérieure et ayant une face supérieure oblique par rapport à la face principale du substrat et ayant une épaisseur plus grande que celles de la partie inférieure et de la partie supérieure;
— une couche active (13) en semi-conducteur formée sur la première couche de revêtement et comportant une partie inférieure horizontale formée sur la partie inférieure de la première couche de revêtement, une partie supérieure horizontale formée sur la partie supérieure de la première couche de revêtement et une région centrale oblique (131) agissant en région laser formée sur la partie centrale de la première couche de revêtement et reliant la partie inférieure horizontale et la partie supérieure horizontale avec une cambrure inférieure et une cambrure supérieure entre elles; et
— une seconde couche de revêtement (14) en semi-conducteur formée sur la couche active, caractérisé en ce que:
— une région (22) d'injection de courant ayant une configuration en forme de bande est formée en contact avec la seconde couche de revêtement à une partie située au-dessus de la région centrale oblique de la couche active et formant ainsi une jonction ohmique avec la seconde couche de revêtement, la joinction ayant une largeur qui est inférieure ou au plus égale à la largeur de la région centrale oblique.

2. Laser à semi-conducteur selon la revendication 1, où une largeur de la région (22) d'injection de courant est inférieure à une largeur dans une vue en plan de la région centrale oblique (131).

3. Laser à semi-conducteur selon la revendication 1, qui comprend en outre:

— une couche (21) en semi-conducteur épitaxiale qui est disposée immédiatement sur la seconde couche de revêtement (14) et présente un type de conductibilité opposé à celui de la seconde couche de revêtement, et la région (22) d'injection de courant s'étend à travers la couche épitaxiale et a le même type de conductibilité que la seconde couche de revêtement.

4. Laser à semi-conducteur selon la revendication 1 où la région centrale oblique (131) de la couche active (13) a une section ayant la forme d'une section d'une lentile convexe.

5. Laser à semi-conducteur selon la revendication 1, où la seconde couche de revêtement (14) présente une face supérieure en forme de gradin.

6. Laser à semi-conducteur selon la revendication 1, où la cambrure inférieure et la cambrure supérieure de la couche active (13) ont une courbure régulière.

7. Laser à semi-conducteur selon la revendication 1, où au moins la partie inférieure à cambrure ou la partie supérieure à cambrure de la couche active (13) est plus fine que d'autres parties de la couche active.

8. Laser à semi-conducteur selon la revendication 1, où la région centrale oblique (131) est formée obliquement par rapport à la face de la partie fine due substrat sur une partie du gradin du substrat (11).

9. Laser à semi-conducteur selon la revendication 1, où le substrat en semi-conducteur (11), la couche active (13) et les couches de revêtement (12, 14) sont en semi-conducteur des composées III—V.

10. Laser à semi-conducteur selon la revendication 1, où la résistivité spécifique de la seconde couche de revêtement (14) est 10⁻²Ω·cm ou plus.

11. Laser à semi-conducteur selon la revendication 1, où la seconde couche de revêtement (14) a une partie oblique sur la région centrale oblique (131) de la couche active (13), et dans la seconde couche de revêtement la partie oblique est plus épaisse que d'autres parties de la seconde couche de revêtement.

12. Laser à semi-conducteur selon la revendication 3, où la face supérieure de la seconde couche de revêtement (14) a une partie oblique au-dessus de la région central oblique (131), où est en contact la région (22) d'injection de courant.

13. Laser à semi-conducteur selon la revendication 3, où la couche épitaxiale est constituée de deux couches (21, 40) du même type de conductibilité.

14. Laser à semi-conducteur selon la revendication 3, où une jonction entre la seconde couche de revêtement (14) et la couche épitaxiale (21) a une partie de cambrage au-dessus de la cambrure de la couche active (13) et un bord d'angle inférieure (221) de la région (22) d'injection de courant qui est plus proche de la région centrale oblique (131) pénètre la jonction pour entrer dans la seconde couche de revêtement et un autre bord d'angle inférieur reste dans la couche épitaxiale.

15. Laser à semi-conducteur selon la revendication 3 où la région (22) d'injection de courant est une région à diffusion Zn.

FIG.1

(PRIOR ART I)

position

position

FIG.2

(PRIOR ART II)

FIG.3

(PRIOR ART III)

FIG.4

# F I G. 5

$\rho_3$ ($\Omega \cdot cm$)

S = 5. 4. 2 ($\mu$m)

Current confinement factor

d31= 0.5$\mu$m
d32= 1 $\mu$m
D=5$\mu$m
I =100mA
$\sin\theta$=0.1

# F I G.6

$\rho_3$ ($\Omega \cdot cm$)

S = 5. 4. 2

Current confinement factor

d31=1$\mu$m
d32=3$\mu$m
D=5$\mu$m
I =100mA
$\sin\theta$=0.4

2

FIG.7 (A)

FIG.7 (B)

FIG.7 (C)

# F I G. 8

$P_3$
( Ω-cm )

S=5μm

threshold current (mA)

d31=1μm
d32=25μm
D=5μm
sinθ=0.3

# F I G. 9

threshold current (mA)

II

I

stripe width S(μm)

d31=1μm
d32=25μm
D=5μm
$P_3$=10⁻¹Ω·cm
sinθ=0.3

FIG.10(a)

FIG.10(b)

FIG.10(c)

FIG.10(d)

FIG.11.(a)

11

T

FIG.11(b)

21
14
13
12
11

131    T

FIG.11(c)

221    22

23
21
14
13
12
11
17

T    131

F I G. 11 (d)

FIG.11 (e)

F I G.11 (f)

FIG.11(g)

F I G. 11 (h)

25 °C    4 mW
N₂ ambient
uncoated

λ = 726nm    741nm

760 nm

782 nm

OPERATING CURRENT (mA)

OPERATING TIME (hours)

0 032 401

F I G.12 (a)

F I G.12 (b)

F I G.12 (c)

F I G.12 (d)

FIG.13(a)

17

FIG.13(b)

21
14
13
12
11

131    B

221    22    26

FIG.13(c)

21
14
13
12
11

131    B

221    22

23
21

FIG.13(d)

14
13
12

11
17

131    B

F I G.14

F I G.15

FIG.16 (a)

FIG.16 (b)

FIG.16 (c)

FIG.16 (d)

FIG.16 (e)

FIG.17(a)

FIG.17(b)

FIG.18(a)

FIG.18(b)

F I G.19

F I G.20 (a)

F I G 20 (b)

FIG. 21(a)

FIG. 21(b)

FIG. 21(c)

FIG. 21(d)